# EUROPEAN PATENT APPLICATION

(11) **EP 4 668 317 A1**
(43) Date of publication of application: **24.12.2025**
(21) Application number: 24756599.7
(22) Date of filing: 25.01.2024
(51) Int. Cl.: H01L 21/304, H01L 21/306

(54) **SUBSTRATE PROCESSING APPARATUS AND SUBSTRATE PROCESSING METHOD**

(30) Priority: 17.02.2023 JP 2023023743
(71) Applicant: SCREEN Holdings Co., Ltd., Kyoto-shi, Kyoto 602-8585 (JP)
(72) Inventor: TAKAGI, Keisuke, Kyoto-shi, Kyoto 602-8585 (JP); HIGASHI, Katsuei, Kyoto-shi, Kyoto 602-8585 (JP); TAKEMATSU, Yusuke, Kyoto-shi, Kyoto 602-8585 (JP); HIRATA, Tetsuya, Kyoto-shi, Kyoto 602-8585 (JP)
(74) Representative: Kilian Kilian & Partner mbB
(86) International application number: PCT/JP2024/002256
(87) International publication number: WO 2024/171748

(57) **Abstract**

A substrate processing apparatus (1) discharges a processing liquid obtained by mixing a plurality of types of liquids to a substrate W. The substrate processing apparatus (1) includes a predetermined liquid storage tank (54), a same-type liquid supplying portion (200), a discharge portion (20), and a recovery portion (110). The predetermined liquid storage tank (54) stores a predetermined liquid as one of a plurality of types of liquids used to generate a processing liquid. The same-type liquid supplying portion (200) includes a first storage tank (204) that stores a first same-type liquid which is a liquid of the same type as the predetermined liquid. The discharge portion (20) discharges the first same-type liquid to the substrate W before the processing liquid is discharged to the substrate W. The recovery portion(110) recovers the first same-type liquid discharged to the substrate W and supplies the first same-type liquid to the first storage tank (204). The temperature of the first same-type liquid is higher than room temperature. The first same-type liquid is not used as any liquid among the plurality of types of liquids.

## Description

### Technical Field

The present invention relates to a substrate processing apparatus and a substrate processing method.

### Background Art

In a substrate processing apparatus described in Patent Document 1, a liquid is discharged from a processing liquid supplying portion toward an upper surface of a substrate rotated by a substrate rotation mechanism. The processing liquid supplying portion includes a sulfuric acid supplying portion, a hydrogen peroxide water supplying portion, a mixed liquid generating portion, and a nozzle. In the substrate processing apparatus, sulfuric acid heated by the sulfuric acid supplying portion is supplied from the nozzle to the substrate, and a preheating process is performed on the substrate. Thereafter, the heated sulfuric acid from the sulfuric acid supplying portion and the hydrogen peroxide water from the hydrogen peroxide water supplying portion are mixed in the mixed liquid generating portion to generate an SPM (sulfuric acid hydrogen peroxide mixture), and the SPM is supplied to the substrate to perform the SPM processing.

### Citation List

### Patent Literature

Patent Literature 1 : Japanese Patent Application Publication No. 2013-74090

### Summary of Invention

### Technical Problem

However, in the substrate processing apparatus described in Patent Literature 1, a recovery portion recovers the sulfuric acid supplied to the substrate at the time of the preheating process and returns the sulfuric acid to the sulfuric acid supplying portion. Therefore, the SPM used in the SPM processing contains the recovered sulfuric acid. As a result, when the number of times of the SPM processing increases, the cleanliness of the SPM may decrease.

That is, the liquid (for example, sulfuric acid) discharged to the substrate before discharging the processing liquid (for example, SPM) is reused to generate the processing liquid. Therefore, the cleanliness of the processing liquid may be lowered.

The present invention has been made in view of the above problems, and an object of the present invention is to provide a substrate processing apparatus and a substrate processing method capable of reusing a liquid discharged onto a substrate before discharging a processing liquid while suppressing a decrease in cleanliness of the processing liquid.

### Solution to Problem

According to one aspect of the present invention, a substrate processing apparatus processes a substrate by discharging a processing liquid obtained by mixing a plurality of types of liquids to the substrate. The substrate processing apparatus includes a substrate holding portion, a predetermined liquid storage tank, a same-type liquid supplying portion, a discharge portion, and a recovery portion. The substrate holding portion holds and rotates the substrate. The predetermined liquid storage tank stores a predetermined liquid that is any one of the plurality of types of liquids used to generate the processing liquid. The same-type liquid supplying portion includes a first storage tank that stores a first same-type liquid which is a liquid of the same type as the predetermined liquid, and supplies the first same-type liquid. The discharge portion discharges the first same-type liquid supplied from the same-type liquid supplying portion to the substrate before discharging the processing liquid derived from the predetermined liquid to the substrate. The recovery portion recovers the first same-type liquid discharged to the substrate and supplies the first same-type liquid to the first storage tank. A temperature of the first same-type liquid supplied from the same-type liquid supplying portion is higher than the room temperature. The first same-type liquid is not used as any liquid among the plurality of types of liquids.

In a preferred embodiment, a temperature of the first same-type liquid when the first same-type liquid is discharged to the substrate is preferably approximately equal to a temperature of the processing liquid when discharged to the substrate.

In a preferred embodiment, a temperature of the first same-type liquid when discharged to the substrate is preferably higher than a temperature of the predetermined liquid when the processing liquid is generated.

In a preferred embodiment, the same-type liquid supplying portion preferably includes a second storage tank and a liquid supplying portion. The second storage tank preferably stores a second same-type liquid which is at room temperature and of the same type as the predetermined liquid. The liquid supplying portion preferably mixes the first same-type liquid and the second same-type liquid, supplies the mixed liquid to the discharge portion as a new first same-type liquid. The liquid supplying portion preferably includes a heating portion that heats the first same-type liquid stored in the first storage tank.

In a preferred embodiment, the processing liquid is a sulfuric acid hydrogen peroxide mixture in which sulfuric acid and hydrogen peroxide water are mixed, and the first same-type liquid is preferably sulfuric acid.

In a preferred embodiment, it is preferable that the processing liquid is an ammonia hydrogen peroxide mixture in which ammonia water, hydrogen peroxide water, and water are mixed, the first same-type liquid is water, or the processing liquid is a hydrochloric acid hydrogen peroxide mixture in which hydrochloric acid, hydrogen peroxide water, and water are mixed, and the first same-type liquid is water.

According to another aspect of the present invention, a substrate processing method processes a substrate by discharging a processing liquid, obtained by mixing a plurality of types of liquids, to the substrate. A substrate processing method includes a step of discharging a processing liquid derived from a predetermined liquid to the substrate, a step of discharging a first same-type liquid, which is a liquid of the same type as the predetermined liquid, to the substrate before discharging the processing liquid to the substrate, and a step of recovering the first same-type liquid discharged to the substrate and supplying the first same-type liquid to a first storage tank. The predetermined liquid is any one of the plurality of types of liquids used to generate the processing liquid. A temperature of the first same-type liquid when discharged to the substrate is higher than room temperature. In the step of discharging the first same-type liquid to the substrate, the first same-type liquid stored in the first storage tank is reused. The first same-type liquid is not used as any liquid among the plurality of types of liquids.

In a preferred embodiment, a temperature of the first same-type liquid when discharged to the substrate is preferably approximately equal to a temperature of the processing liquid when discharged to the substrate.

In a preferred embodiment, a temperature of the first same-type liquid when discharged to the substrate is preferably higher than a temperature of the predetermined liquid when the processing liquid is generated.

In a preferred embodiment, in the step of discharging the first same-type liquid to the substrate, it is preferable that the heated first same-type liquid from the first storage tank and the second same-type liquid, which is at room temperature from the second storage tank are mixed, and the mixed liquid is discharged to the substrate as a new first same-type liquid. The second same-type liquid is preferably of the same type as the predetermined liquid.

In a preferred embodiment, the processing liquid is a sulfuric acid hydrogen peroxide mixture in which sulfuric acid and hydrogen peroxide water are mixed, and the first same-type liquid is preferably sulfuric acid.

In a preferred embodiment, it is preferable that the processing liquid is an ammonia hydrogen peroxide mixture in which ammonia water, hydrogen peroxide water, and water are mixed, the first same-type liquid is water, or the processing liquid is a hydrochloric acid hydrogen peroxide mixture in which hydrochloric acid, hydrogen peroxide water, and water are mixed, and the first same-type liquid is water.

### Advantageous Effects of Invention

According to the present invention, it is possible to reuse the liquid discharged to the substrate before discharging the processing liquid while suppressing a decrease in cleanliness of the processing liquid.

### Brief Description of Drawings

[FIG. 1] is a schematic side view illustrating the inside of a substrate processing apparatus according to Preferred Embodiment 1 of the present invention.
[FIG. 2] is a graph illustrating a relationship between a front surface temperature and a processing time of a substrate.
[FIG. 3] is a graph illustrating a relationship between a resist peeling time and a first sulfuric acid discharge time.
[FIG. 4] is a flowchart illustrating a substrate processing method performed by the substrate processing apparatus according to the Preferred Embodiment 1.
[FIG. 5] is a schematic side view illustrating the inside of a substrate processing apparatus according to a modified example of the Preferred Embodiment 1.
[FIG. 6] is a flowchart illustrating a substrate processing method performed by a substrate processing apparatus according to the modified example of the Preferred Embodiment 1.
[FIG. 7] is a schematic side view illustrating the inside of a substrate processing apparatus according to Preferred Embodiment 2 of the present invention.
[FIG. 8] is a schematic side view illustrating the inside of a substrate processing apparatus according to a modified example of Preferred Embodiment 2.

### Description of Embodiments

Preferred embodiments of the present invention shall now be described with reference to the drawings. In the drawings, the same or corresponding portions are denoted by the same reference numerals, and the description thereof will not be repeated.

Various substrates such as a semiconductor wafer (for example, silicon wafers), a glass substrate for a photomask, a glass substrate for a liquid crystal display, a glass substrate for a plasma display, a substrate for a field emission display (FED), a substrate for an optical disk, a substrate for a magnetic disk, and a substrate for a magneto-optical disk can be applied to a "substrate" to be subjected to substrate processing in the substrate processing apparatus according to the present invention. Hereinafter, a preferred embodiment of the present invention will be mainly described by taking an example of a case where a disk-shaped semiconductor wafer is to be subjected to substrate processing, but the substrate processing apparatus according to the present invention is similarly applicable to various substrates other than the semiconductor wafer described above. Also, the shape of the substrate is not limited to the disk shape, and the substrate processing apparatus according to the present invention can be applied to substrates having various shapes.

### (Preferred Embodiment 1)

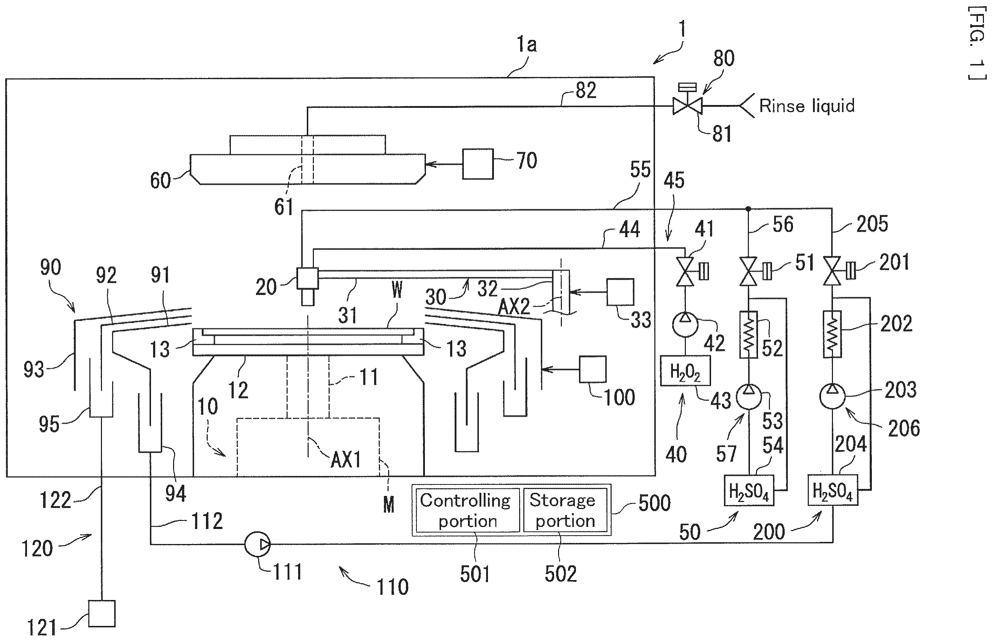

A substrate processing apparatus 1 according to Preferred Embodiment 1 of the present invention will be described with reference to FIGS. 1 to 4. FIG. 1 is a schematic side view illustrating the inside of the substrate processing apparatus 1 according to Preferred Embodiment 1. The substrate processing apparatus 1 processes a substrate W using a processing liquid. More specifically, the substrate processing apparatus 1 is a single substrate processing type, and processes the substrates W one by one. The processing liquid is, for example, a chemical liquid.

In Preferred Embodiment 1, the substrate processing apparatus 1 processes the substrate W by discharging a processing liquid obtained by mixing a plurality of types of liquids to the substrate W. In this case, the substrate processing apparatus 1 discharges the first same-type liquid to the substrate W before discharging the processing liquid to the substrate W. The first same-type liquid is the same type of liquid as the predetermined liquid. The predetermined liquid is one of a plurality of types of liquids used to generate a processing liquid. The temperature of the first same-type liquid is higher than the room temperature. Therefore, it is possible to suppress a decrease in the temperature of the processing liquid supplied to the substrate W during the processing by the processing liquid performed after the first same-type liquid is discharged. As a result, the efficiency of the processing of the substrate W with the processing liquid can be improved. That is, it is possible to realize desired processing of the substrate W with the processing liquid while reducing the amount of the processing liquid used. The processing liquid can be regarded as a liquid derived from a predetermined liquid. This is because the predetermined liquid is any liquid among a plurality of types of liquids used to generate the processing liquid.

In the present specification, the "room temperature" is, for example, a temperature of 20°C or more and 30°C or less.

Hereinafter, as an example, the processing liquid is a sulfuric acid hydrogen peroxide mixture (SPM). The SPM is a mixed liquid of sulfuric acid (H₂SO₄) and hydrogen peroxide water (H₂O₂). In the case of the SPM, the plurality of types of liquids are sulfuric acid and hydrogen peroxide water. Also, as an example, the predetermined liquid that is any liquid among a plurality of types of liquids is sulfuric acid. Furthermore, as an example, the first same-type liquid is sulfuric acid. Hereinafter, sulfuric acid as the predetermined liquid will be simply described as "sulfuric acid," and sulfuric acid as the first same-type liquid will be described as "first sulfuric acid." The SPM can be regarded as a liquid derived from sulfuric acid. This is because sulfuric acid is any liquid among a plurality of types of liquids used to generate SPM.

The substrate processing apparatus 1 mixes sulfuric acid and hydrogen peroxide water to generate an SPM, and processes the substrate W with the SPM. In Preferred Embodiment 1, the substrate processing apparatus 1 supplies the SPM to the substrate W to peel off the resist film from the substrate W. In this case, the substrate processing apparatus 1 discharges the first sulfuric acid to the substrate W before discharging the processing liquid to the substrate W. The temperature of the first sulfuric acid is higher than the room temperature. Therefore, it is possible to suppress a decrease in the temperature of the SPM supplied to the substrate W at the time of processing by the SPM performed after discharging the first sulfuric acid. As a result, the efficiency of the processing of the substrate W by the SPM can be improved. That is, it is possible to realize desired processing (peeling of the resist film) by the SPM on the substrate W while reducing the use amount of the SPM.

Specifically, as illustrated in FIG. 1, the substrate processing apparatus 1 includes a chamber 1a, a spin chuck 10, a chemical liquid nozzle 20, a chemical liquid nozzle moving mechanism 30, a hydrogen peroxide water supplying portion 40, a sulfuric acid supplying portion 50, a same-type liquid supplying portion 200, an opposing member 60, a first elevating/lowering portion 70, a rinse liquid supplying portion 80, a liquid receiving portion 90, a second elevating/lowering portion 100, a recovery portion 110, a disposal portion 120, and a controller 500.

The chamber 1a has an internal space. In the example of FIG. 1, the chamber 1a accommodates the spin chuck 10, the chemical liquid nozzle 20, the chemical liquid nozzle moving mechanism 30, a part of the hydrogen peroxide water supplying portion 40, a part of the sulfuric acid supplying portion 50, a part of the same-type liquid supplying portion 200, the opposing member 60, the first elevating/lowering portion 70, a part of the rinse liquid supplying portion 80, the liquid receiving portion 90, and the second elevating/lowering portion 100. The spin chuck 10 corresponds to an example of a "substrate holding portion" of the present invention. The chemical liquid nozzle 20 corresponds to an example of a "discharge portion" of the present invention.

The spin chuck 10 holds and rotates the substrate W. Specifically, the spin chuck 10 holds one substrate W in a horizontal posture and rotates the substrate W around a vertical rotational axis AX1 passing through the center of the substrate W. As the spin chuck 10, a gripping-type chuck that horizontally holds the substrate W while horizontally clamping the substrate W is adopted.

Specifically, the spin chuck 10 includes a spin motor M, a spin shaft 11, a spin base 12, and a plurality of gripping members 13. The spin shaft 11 is integrated with a drive shaft of the spin motor M. The spin base 12 has a substantially disk shape. The spin base 12 is attached substantially horizontally to the upper end of the spin shaft 11. The plurality of gripping members 13 are located on the upper surface of the spin base 12. The plurality of gripping members 13 are located at intervals on the circumference corresponding to the outer peripheral shape of the substrate W in the peripheral edge potion of the upper surface of the spin base 12. The plurality of gripping members 13 grips the peripheral end surface of the substrate W. The spin motor M rotates the spin base 12 around the rotational axis AX1 to rotate the substrate W gripped by the plurality of gripping members 13 around the rotational axis AX1.

When processing the substrate W (that is, in a case where the resist film of the substrate W is peeled off,), the chemical liquid nozzle 20 discharges the SPM to the rotating substrate W. The SPM corresponds to an example of the "processing liquid" of the present invention.

When the chemical liquid nozzle 20 discharges the SPM to the substrate W, the hydrogen peroxide water supplying portion 40 supplies hydrogen peroxide water to the chemical liquid nozzle 20. Specifically, the hydrogen peroxide water supplying portion 40 includes a hydrogen peroxide water storage tank 43 and a supplying portion 45. The hydrogen peroxide water storage tank 43 stores hydrogen peroxide water. The supplying portion 45 supplies the hydrogen peroxide water stored in the hydrogen peroxide water storage tank 43 to the chemical liquid nozzle 20.

The supplying portion 45 includes a valve 41, a pump 42, and a piping 44.

One end of the piping 44 is connected to the chemical liquid nozzle 20. The piping 44 extends from the chemical liquid nozzle 20 to the hydrogen peroxide water storage tank 43.

The valve 41 is disposed in the piping 44. The valve 41 opens and closes a flow path of the piping 44. Hydrogen peroxide water at room temperature whose temperature is not adjusted is supplied from the hydrogen peroxide water storage tank 43 to the piping 44. When the valve 41 is opened, hydrogen peroxide water is supplied from the piping 44 to the chemical liquid nozzle 20. The hydrogen peroxide water corresponds to an example of "another liquid among a plurality of types of liquids" in the present invention.

When the chemical liquid nozzle 20 discharges the SPM to the substrate W, the sulfuric acid supplying portion 50 supplies sulfuric acid (specifically, a new liquid of sulfuric acid) to the chemical liquid nozzle 20. Specifically, the sulfuric acid supplying portion 50 includes a sulfuric acid storage tank 54 and a supplying portion 57. The sulfuric acid storage tank 54 stores sulfuric acid (specifically, a new liquid of sulfuric acid). The supplying portion 57 supplies the sulfuric acid stored in the sulfuric acid storage tank 54 to the chemical liquid nozzle 20.

The sulfuric acid storage tank 54 corresponds to an example of a "predetermined liquid storage tank" of the present invention. The sulfuric acid (specifically, a new liquid of sulfuric acid) stored in the sulfuric acid storage tank 54 corresponds to an example of the "predetermined liquid" of the present invention.

The supplying portion 57 includes a valve 51, a heating portion 52, a pump 53, a common piping 55, and a piping 56.

One end of the common piping 55 is connected to the chemical liquid nozzle 20. The other end of the common piping 55 is connected to one end of the piping 56. The other end of the piping 56 extends to the sulfuric acid storage tank 54. In the piping 56, the pump 53, the heating portion 52, and the valve 51 are disposed in this order from upstream to downstream.

The pump 53 sends the sulfuric acid stored in the sulfuric acid storage tank 54 to the piping 56. That is, the pump 53 supplies the sulfuric acid stored in the sulfuric acid storage tank 54 to the piping 56. The heating portion 52 heats sulfuric acid flowing through the piping 56 to set the temperature of sulfuric acid to the target temperature T0. The valve 51 opens and closes a flow path of the piping 56. The target temperature T0 is higher than the room temperature. The heating portion 52 is, for example, a heater.

The piping 56 branches between the heating portion 52 and the valve 51 and is connected to the sulfuric acid storage tank 54. In a state where the valve 51 is closed, the sulfuric acid heated by the heating portion 52 circulates through the sulfuric acid storage tank 54 and the heating portion 52. Therefore, the temperature of the sulfuric acid stored in the sulfuric acid storage tank 54 is set to the target temperature T0.

When the valve 51 is opened, the sulfuric acid set to the target temperature T0 is supplied from the piping 56 to the common piping 55, and further supplied from the common piping 55 to the chemical liquid nozzle 20.

The sulfuric acid supplied from the sulfuric acid storage tank 54 to the chemical liquid nozzle 20 and the hydrogen peroxide water supplied from the hydrogen peroxide water storage tank 43 to the chemical liquid nozzle 20 are mixed in the chemical liquid nozzle 20 to generate an SPM. Then, the chemical liquid nozzle 20 discharges the SPM to the rotating substrate W. As a result, the substrate W is processed by the SPM. That is, the resist film of the substrate W is peeled off by the SPM.

When the chemical liquid nozzle 20 discharges the SPM to the substrate W, a valve 201 is closed. The temperature of the SPM at the time of discharge from the chemical liquid nozzle 20 is, for example, 100°C or more and 200°C or less.

The chemical liquid nozzle 20 discharges the first sulfuric acid to the substrate W before discharging the SPM to the substrate W. When the chemical liquid nozzle 20 discharges the first sulfuric acid to the substrate W, the valve 41 and the valve 51 are closed.

When the chemical liquid nozzle 20 discharges the first sulfuric acid to the substrate W, the same-type liquid supplying portion 200 supplies the first sulfuric acid. Specifically, the same-type liquid supplying portion 200 supplies the first sulfuric acid to the chemical liquid nozzle 20.

The same-type liquid supplying portion 200 includes a supplying portion 206 and a first storage tank 204. The supplying portion 206 supplies the first sulfuric acid stored in the first storage tank 204 to the chemical liquid nozzle 20. The first storage tank 204 stores the first sulfuric acid.

The first sulfuric acid stored in the first storage tank 204 corresponds to an example of "first same-type liquid" of the present invention.

The supplying portion 206 includes a valve 201, a heating portion 202, a pump 203, and a piping 205.

One end of the common piping 55 is connected to the chemical liquid nozzle 20. The other end of the common piping 55 is connected to one end of the piping 205. The other end of the piping 205 extends to the first storage tank 204. In the piping 205, the pump 203, the heating portion 202, and the valve 201 are disposed in this order from upstream to downstream.

The pump 203 sends the first sulfuric acid stored in the first storage tank 204 to the piping 205. That is, the pump 203 supplies the first sulfuric acid stored in the first storage tank 204 to the piping 205. The heating portion 202 heats the first sulfuric acid flowing through the piping 205 to set the temperature of the first sulfuric acid to the target temperature T1. The valve 201 opens and closes a flow path of the piping 205. The heating portion 202 is, for example, a heater.

The piping 205 branches between the heating portion 202 and the valve 201 and is connected to the first storage tank 204. In a state where the valve 201 is closed, the sulfuric acid heated by the heating portion 202 circulates through the first storage tank 204 and the heating portion 202. Therefore, the temperature of the first sulfuric acid stored in the first storage tank 204 is set to the target temperature T1. The target temperature T1 is higher than the room temperature.

When the valve 201 is opened while the valve 51 and the valve 41 are closed, the first sulfuric acid set to the target temperature T1 is supplied from the piping 205 to the common piping 55, and further supplied from the common piping 55 to the chemical liquid nozzle 20. As a result, the chemical liquid nozzle 20 discharges the first sulfuric acid to the substrate W before discharging the SPM to the substrate W. Therefore, the front surface of the substrate W and the chemical liquid nozzle 20 are temperature-controlled to a temperature higher than the room temperature before the SPM is discharged to the substrate W. That is, the front surface of the substrate W and the chemical liquid nozzle 20 are preheated before the SPM is discharged to the substrate W. As a result, it is possible to suppress a decrease in the temperature of the SPM supplied to the substrate W at the time of processing by the SPM performed after discharging the first sulfuric acid.

The chemical liquid nozzle moving mechanism 30 moves the chemical liquid nozzle 20 along a horizontal plane. The chemical liquid nozzle moving mechanism 30 moves the chemical liquid nozzle 20 between the retraction position and the processing position. The retraction position is a position outside the spin chuck 10. In Preferred Embodiment 1, the processing position is a position opposing the center of the substrate W. The chemical liquid nozzle 20 supplies the first sulfuric acid or SPM to the substrate W from the processing position.

The chemical liquid nozzle moving mechanism 30 includes a nozzle arm 31, a nozzle base 32, and a nozzle moving portion 33. The nozzle base 32 extends in the vertical direction. A base end portion of the nozzle arm 31 is coupled to the nozzle base 32. The nozzle arm 31 extends horizontally from the nozzle base 32.

The nozzle arm 31 supports the chemical liquid nozzle 20. The chemical liquid nozzle 20 protrudes vertically downward from the nozzle arm 31. The chemical liquid nozzle 20 is located at a distal end portion of the nozzle arm 31.

The nozzle moving portion 33 rotates the nozzle base 32 around a rotational axis AX2 extending in the vertical direction. As a result, the chemical liquid nozzle 20 moves along the circumferential direction around the rotational axis AX2. The nozzle moving portion 33 can elevate or lower the nozzle base 32. As a result, the chemical liquid nozzle 20 is elevated or lowered. The nozzle moving portion 33 includes, for example, a motor for rotating the nozzle base 32. The nozzle moving portion 33 includes, for example, a ball screw mechanism and an electric motor that applies a driving force to the ball screw mechanism in order to elevate and lower the nozzle base 32.

The opposing member 60 faces the substrate W. Specifically, the opposing member 60 is located above the substrate W. The opposing member 60 supplies the rinse liquid to the rotating substrate W. Specifically, the opposing member 60 includes a rinse liquid nozzle 61. The rinse liquid nozzle 61 supplies the rinse liquid to the rotating substrate W. That is, the rinse liquid nozzle 61 discharges the rinse liquid toward the rotating substrate W.

Specifically, the rinse liquid supplying portion 80 supplies the rinse liquid to the rinse liquid nozzle 61. The rinse liquid supplying portion 80 includes a valve 81 and a piping 82. The piping 82 is connected to the rinse liquid nozzle 61. The valve 81 is disposed in the piping 82. The valve 81 opens and closes a flow path of the piping 82. A rinse liquid is supplied from a rinse liquid supply source (not illustrated) to the piping 82. When the valve 81 is opened, the rinse liquid is supplied from the piping 82 to the rinse liquid nozzle 61. As a result, the rinse liquid nozzle 61 discharges the rinse liquid toward the rotating substrate W.

The rinse liquid is deionized water (DIW), so-called "pure water." However, the rinse liquid is not limited to deionized water. For example, the rinse liquid may be carbonated water, electrolyzed ion water, hydrogen water, ozone water, ammonia water, or diluted hydrochloric acid water (for example, hydrochloric acid water having a concentration of about 10 ppm to 100 ppm).

The first elevating/lowering portion 70 elevates and lowers the opposing member 60. Specifically, the first elevating/lowering portion 70 elevates and lowers the opposing member 60 between the processing position and the retraction position. The retraction position is a position above the processing position. The processing position is a position closer to the substrate W than the retraction position. The first elevating/lowering portion 70 includes, for example, a ball screw mechanism and an electric motor that applies a driving force to the ball screw mechanism. The opposing member 60 (rinse liquid nozzle 61) supplies the rinse liquid to the substrate W from the processing position. The opposing member 60 covers the substrate W from above at the processing position.

The liquid receiving portion 90 receives liquid (SPM, first sulfuric acid, or rinse liquid) scattered from the substrate W. Specifically, the liquid receiving portion 90 includes a first guard 91, a first cup 94, a second guard 92, a second cup 95, and a third guard 93.

The first guard 91 has a substantially cylindrical shape surrounding the spin chuck 10 and is located around the spin chuck 10. In Preferred Embodiment 1, the first guard 91 receives the first sulfuric acid scattered from the rotating substrate W.

The first cup 94 is located on the lower end side of the first guard 91. The first cup 94 defines an annular groove below the lower end of the first guard 91. In Preferred Embodiment 1, first sulfuric acid flowing down from the inner peripheral surface of the first guard 91 is collected in the first cup 94. The first sulfuric acid collected in the first cup 94 is recovered by the recovery portion 110 connected to the bottom portion of the first cup 94.

The second guard 92 has a substantially cylindrical shape surrounding the first guard 91, and is located around the first guard 91. In Preferred Embodiment 1, the second guard 92 receives the SPM scattered from the rotating substrate W.

The second cup 95 is located on the lower end side of the second guard 92. The second cup 95 defines an annular groove below the lower end of the second guard 92. The SPM flowing down from the inner peripheral surface of the second guard 92 is collected in the second cup 95.

The SPM collected in the second cup 95 is discarded by the disposal portion 120 connected to the bottom portion of the second cup 95. The disposal portion 120 includes a disposal unit 121 and a drainage piping 122. The drainage piping 122 is connected to the bottom portion of the second cup 95 and extends to the disposal unit 121. The SPM collected in the second cup 95 flows into the drainage piping 122. Then, the SPM is supplied from the drainage piping 122 to the disposal unit 121. As a result, the disposal unit 121 discards the SPM.

The third guard 93 has a substantially cylindrical shape surrounding the second guard 92, and is located around the second guard 92. The third guard 93 can receive liquid scattered from the rotating substrate W.

The second elevating/lowering portion 100 individually elevates and lowers the first guard 91, the second guard 92, and the third guard 93. The second elevating/lowering portion 100 is controlled by a controlling portion 501. The second elevating/lowering portion 100 includes, for example, a ball screw mechanism and an electric motor that applies a driving force to the ball screw mechanism.

Specifically, the second elevating/lowering portion 100 switches to any one of a retraction state in which the upper ends of the first guard 91, the second guard 92, and the third guard 93 are located below the substrate W, a first opposing state (state illustrated in FIG. 1) in which the first guard 91 faces the peripheral end surface of the substrate W, a second opposing state in which the second guard 92 faces the peripheral end surface of the substrate W, and a third opposing state in which the third guard 93 faces the peripheral end surface of the substrate W.

More specifically, in the first opposing state of the liquid receiving portion 90, the first guard 91, the second guard 92, and the third guard 93 are located at the upper position (processing height position) (FIG. 1). In the first opposing state, as an example, the first guard 91 receives the first sulfuric acid scattered from the substrate W.

In the second opposing state of the liquid receiving portion 90, the second guard 92 and the third guard 93 are located at the upper position, and the first guard 91 is located at the lower position. In the second opposing state, as an example, the second guard 92 receives the SPM scattered from the substrate W.

In the third opposing state of the liquid receiving portion 90, the third guard 93 is located at the upper position, and the first guard 91 and the second guard 92 are located at the lower positions. In the retraction state of the liquid receiving portion 90, the first guard 91, the second guard 92, and the third guard 93 are located at the lower positions.

The recovery portion 110 recovers the first sulfuric acid discharged to the substrate W and supplies the first sulfuric acid to the first storage tank 204. Specifically, the recovery portion 110 recovers the first sulfuric acid scattered from the substrate W through the first guard 91 and the first cup 94.

The recovery portion 110 includes a recovery pump 111 and a recovery piping 112. The recovery piping 112 is connected to the bottom portion of the first cup 94 and extends to the first storage tank 204. The recovery pump 111 is disposed in the recovery piping 112. The recovery pump 111 sends the first sulfuric acid recovered from the first cup 94 to the first storage tank 204. As a result, the first sulfuric acid recovered by the recovery portion 110 is stored in the first storage tank 204 and reused. That is, the recovered first sulfuric acid is reused when preheating the chemical liquid nozzle 20 and the front surface of the substrate W before discharging the SPM to the substrate W.

When the chemical liquid nozzle 20 discharges the first sulfuric acid, the valves 41 and 51 are closed. Therefore, the first sulfuric acid stored in the first storage tank 204 is used only when preheating the chemical liquid nozzle 20 and the front surface of the substrate W before discharging the SPM to the substrate W. In other words, the first sulfuric acid stored in the first storage tank 204 is not used as any liquid among the plurality of types of liquids used to generate the SPM. Moreover, the first sulfuric acid stored in the first storage tank 204 is not used as the sulfuric acid used to generate the SPM. As described above, the recovered first sulfuric acid is not supplied to the sulfuric acid storage tank 54 and is not mixed with the sulfuric acid in the sulfuric acid storage tank 54.

Therefore, it is possible to prevent the cleanliness of sulfuric acid (sulfuric acid stored in the sulfuric acid storage tank 54) used to generate the SPM from being lowered by the first sulfuric acid. In other words, the cleanliness of the SPM can be prevented from being lowered by the first sulfuric acid. In other words, according to Preferred Embodiment 1, it is possible to reuse the first sulfuric acid discharged to the substrate W before discharging the SPM while suppressing a decrease in cleanliness of the SPM.

That is, according to Preferred Embodiment 1, it is possible to reuse the first same-type liquid (liquid) discharged to the substrate W before discharging the processing liquid while suppressing a decrease in cleanliness of the processing liquid.

The controller 500 controls the operation of each portion of the substrate processing apparatus 1. The controller 500 is, for example, a computer. Specifically, the controller 500 includes a controlling portion 501 and a storage portion 502.

The controlling portion 501 controls the operation of each portion of the substrate processing apparatus 1 on the basis of various types of information stored in the storage portion 502. For example, the controlling portion 501 controls the spin chuck 10, the chemical liquid nozzle moving mechanism 30, the hydrogen peroxide water supplying portion 40, the sulfuric acid supplying portion 50, the same-type liquid supplying portion 200, the first elevating/lowering portion 70, the rinse liquid supplying portion 80, the second elevating/lowering portion 100, the recovery portion 110, and the disposal portion 120 on the basis of various types of information stored in the storage portion 502.

The controlling portion 501 includes, for example, a processor. The controlling portion 501 may include a central processing unit (CPU) or a micro processing unit (MPU) as a processor. Alternatively, the controlling portion 501 may include a general-purpose computing unit or a specialized computing unit.

The storage portion 502 stores various types of information for controlling the operation of the substrate processing apparatus 1. Specifically, the storage portion 502 includes a storage device, and stores data and a computer program as various types of information. Then, the processor of the controlling portion 501 controls the operation of each unit of the substrate processing apparatus 1 by executing a computer program stored in the storage device of the storage portion 502. The various types of information (data) include recipe data. The recipe data indicates a recipe that defines processing contents, processing conditions, and processing procedures of the substrate W.

More specifically, the storage portion 502 includes a main storage device. The main storage device is, for example, a semiconductor memory. The storage portion 502 may further include an auxiliary storage device. The auxiliary storage device includes, for example, at least one of a semiconductor memory and a hard disk drive. The storage portion 502 may include a removable medium. The storage portion 502 corresponds to an example of a non-transitory computer-readable storage medium.

As described above with reference to FIG. 1, according to Preferred Embodiment 1, the chemical liquid nozzle 20 discharges the first sulfuric acid supplied from the same-type liquid supplying portion 200 to the substrate W before the SPM is discharged to the substrate W. In this case, the temperature of the first sulfuric acid is higher than the room temperature. Therefore, the temperature of the chemical liquid nozzle 20 is increased by the first sulfuric acid before discharging the SPM. In addition, the temperature of the front surface of the substrate W is increased by the first sulfuric acid before discharging the SPM. As a result, it is possible to suppress a decrease in the temperature of the SPM at the start of the processing of the substrate W by the SPM. Therefore, the peeling performance of the resist film by the SPM can be improved. The peeling performance is a peeling amount of the resist film per unit time. When the peeling performance of the resist film by the SPM can be improved, the use amount of the SPM can be reduced. That is, the discarded amount of the SPM can be reduced.

In Preferred Embodiment 1, the temperature of the first sulfuric acid at the time of discharging the first sulfuric acid to the substrate W is preferably approximately equal to the temperature of the SPM at the time of discharging the SPM to the substrate W. According to this preferred example, the power consumption amount used by the heating portion 202 can be reduced as compared with the case where the temperature of the first sulfuric acid is higher than the temperature of the SPM.

In Preferred Embodiment 1, the temperature of the first sulfuric acid at the time of discharging the first sulfuric acid to the substrate W is preferably higher than the temperature of the sulfuric acid at the time of generating the SPM. According to this preferred example, the temperature of the chemical liquid nozzle 20 and the temperature of the front surface of the substrate W can be increased before discharging the SPM as compared with a case where the temperature of the first sulfuric acid is lower than the temperature of the sulfuric acid used to generate the SPM. As a result, it is possible to further suppress a decrease in the temperature of the SPM at the start of the processing of the substrate W by the SPM. Therefore, the peeling performance of the resist film by the SPM can be further improved. In this preferred example, generation of fumes can be suppressed.

For example, the temperature of the first sulfuric acid when the first sulfuric acid is discharged to the substrate W is 150°C, and the temperature of the sulfuric acid when the SPM is generated is 100°C.

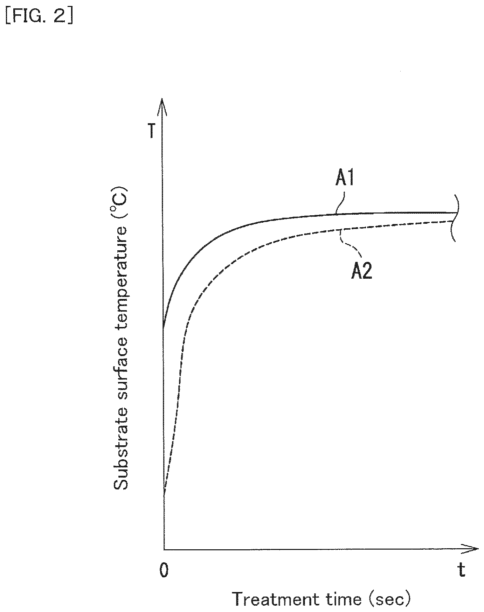

Next, the temporal transition of the surface temperature of the substrate W will be described with reference to FIG. 2. FIG. 2 is a graph illustrating the relationship between the surface temperature T of the substrate W and the processing time t by the SPM. The vertical axis represents the surface temperature T (°C) of the substrate W. The horizontal axis indicates the processing time t (seconds) of the substrate W by the SPM. That is, the horizontal axis indicates the elapsed time t from the time point (0 seconds) when the discharge of the SPM toward the substrate W is started.

In FIG. 2, a curve A1 indicates the surface temperature of the substrate W in Preferred Embodiment 1. That is, the curve A1 indicates a temporal change in the surface temperature of the substrate W when the first sulfuric acid is discharged to the substrate W before the processing by the SPM and thereafter the SPM is discharged to the substrate W. A curve A2 indicates the surface temperature of the substrate W in the comparative example. That is, the curve A2 indicates a temporal change in the surface temperature of the substrate W when the SPM is discharged to the substrate W without discharging the first sulfuric acid before the processing by the SPM.

As can be understood from the comparison between the curve A1 and the curve A2, the surface temperature of the substrate W in the case of discharging the SPM after discharging the first sulfuric acid to the substrate W before the processing by the SPM is higher than the surface temperature of the substrate W in the case of discharging the SPM without discharging the first sulfuric acid before the processing by the SPM. That is, when the SPM is discharged after the first sulfuric acid is discharged to the substrate W before the processing by the SPM, the surface temperature of the substrate W increases faster as compared with the case where the SPM is discharged without discharging the first sulfuric acid before the processing by the SPM.

In particular, at the time point (0 seconds) when the discharge of the SPM is started and in the vicinity thereof, when the first sulfuric acid is discharged to the substrate W before the processing by the SPM, the surface temperature of the substrate W is remarkably higher than the case where the first sulfuric acid is not discharged to the substrate W.

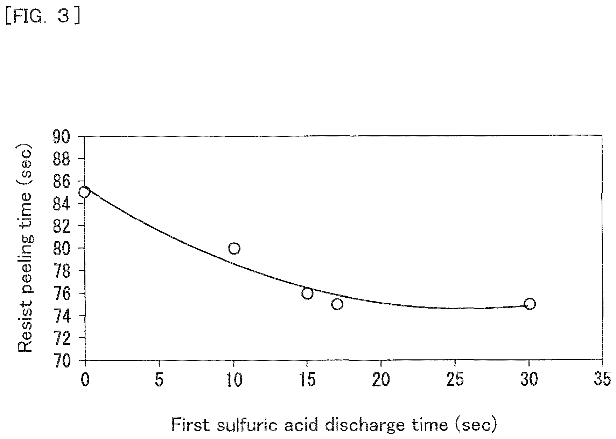

Next, the peeling time of the resist film of the substrate W will be described with reference to FIG. 3. FIG. 3 is a graph illustrating the relationship between the peeling time of the resist film formed on the substrate W and the discharge time of the first sulfuric acid. The vertical axis represents the peeling time (seconds) of the resist film by the SPM. The horizontal axis represents the discharge time (seconds) of the first sulfuric acid.

In FIG. 3, the discharge time of the first sulfuric acid being 0 seconds indicates that the first sulfuric acid was not discharged to the substrate W before the processing by the SPM. That is, a case where the discharge time of the first sulfuric acid is 0 seconds shows a comparative example. In the comparative example, the resist film was peeled off for about 85 seconds by the processing by the SPM.

On the other hand, in a case where the first sulfuric acid is discharged before the processing by the SPM, the peeling time of the resist film by the SPM is shortened as compared with a case where the first sulfuric acid is not discharged before the processing by the SPM (0 seconds). That is, examples of the present invention will be described when the first sulfuric acid is discharged before the processing by the SPM. For example, when the first sulfuric acid was discharged for 20 seconds before the processing by the SPM, the resist film was peeled off for about 75 seconds by the processing by the SPM. In this case, the peeling time of the resist film by the SPM was shortened by about 10 seconds as compared with the case where the first sulfuric acid was not discharged before the processing by the SPM.

As described above with reference to FIG. 3, in this example, the peeling time of the resist film by the SPM can be shortened as compared with the comparative example. That is, in this example, the peeling performance of the resist film could be improved. One reason why the peeling performance of the resist film can be improved is that, as illustrated in FIG. 2, by discharging the first sulfuric acid to the substrate W before the processing by the SPM, the surface temperature of the substrate W has already increased at the start of the discharge of the SPM (0 seconds), and a decrease in the temperature of the SPM on the front surface of the substrate W can be suppressed. Another reason why the peeling performance of the resist film can be improved is that by discharging the first sulfuric acid to the substrate W before the processing by the SPM, the temperature of the chemical liquid nozzle 20 rises at the start of discharge of the SPM (0 seconds), and a decrease in the temperature of the SPM at the time of discharge from the chemical liquid nozzle 20 can be suppressed.

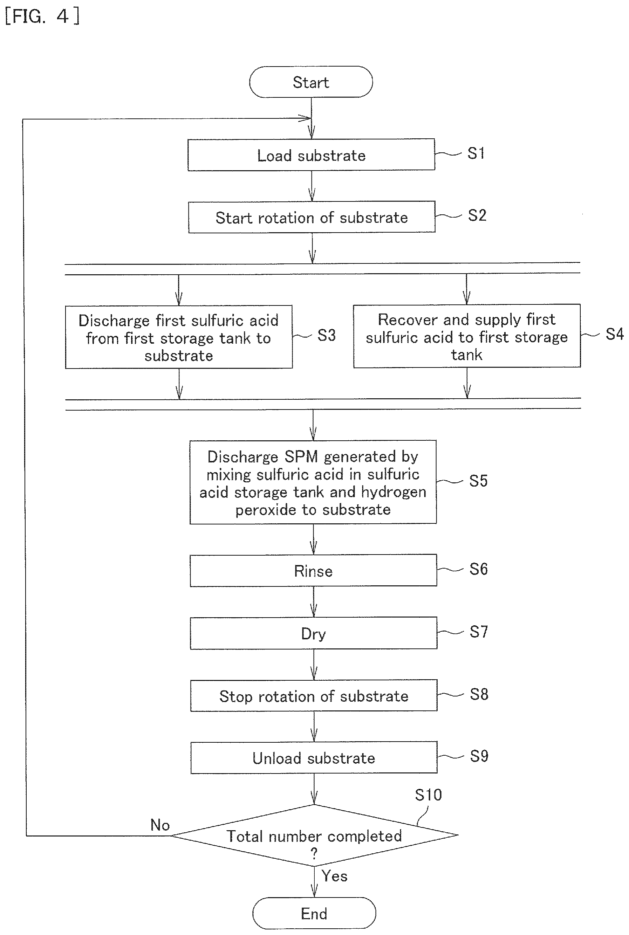

Next, a substrate processing method according to Preferred Embodiment 1 will be described with reference to FIGS. 1 and 4. The substrate processing method is performed in the substrate processing apparatus 1. That is, in the substrate processing method, the substrate W is processed by discharging the SPM in which a plurality of types of liquids (sulfuric acid and hydrogen peroxide water) are mixed to the substrate W.

FIG. 4 is a flowchart illustrating a substrate processing method according to Preferred Embodiment 1; As illustrated in FIG. 4, the substrate processing method includes steps S1 to S10.

As illustrated in FIG. 4, first, in step S1, the controlling portion 501 controls a robot (not illustrated) so as to load the substrate W into the substrate processing apparatus 1. As a result, the robot loads the substrate W into the substrate processing apparatus 1.

Next, in step S2, the controlling portion 501 controls the spin chuck 10 so as to rotate the substrate W. As a result, the spin chuck 10 rotates the substrate W.

Next, step S3 and step S4 are performed in parallel.

In step S3, the controlling portion 501 controls the same-type liquid supplying portion 200 (valve 201) such that the chemical liquid nozzle 20 discharges the first sulfuric acid from the first storage tank 204 to the substrate W. As a result, the valve 201 is opened, and the first sulfuric acid is supplied to the chemical liquid nozzle 20. Therefore, the chemical liquid nozzle 20 discharges the first sulfuric acid to the substrate W. The chemical liquid nozzle 20 and the front surface of the substrate W are preheated by the first sulfuric acid. Step S3 ends, for example, when the first time has elapsed from the start of step S3. That is, the chemical liquid nozzle 20 discharges the first sulfuric acid to the substrate W only during the first time. In step S3, the valves 41, 51, and 81 are closed.

On the other hand, in step S4, the controlling portion 501 controls the recovery portion110 (recovery pump 111) so as to recover the first sulfuric acid scattered from the substrate W and collected in the first cup 94. As a result, the recovery pump 111 is driven, and the first sulfuric acid is recovered in the first storage tank 204 through the recovery piping 112. Step S4 ends, for example, when the second time has elapsed from the start of step S4. The second time may be, for example, substantially the same time as the first time, or may be longer than the first time.

When steps S3 and S4 are completed, the process proceeds to step S5. Even if the process of step S4 is not finished, the process can proceed to step S5 as long as step S3 is finished.

Next, in step S5, the controlling portion 501 controls the hydrogen peroxide water supplying portion 40 (valve 41) and the sulfuric acid supplying portion 50 (valve 51) so that the chemical liquid nozzle 20 discharges the SPM to the substrate W. As a result, the valve 41 and the valve 51 are opened, the hydrogen peroxide water from the hydrogen peroxide water storage tank 43 is supplied to the chemical liquid nozzle 20, and the sulfuric acid from the sulfuric acid storage tank 54 is supplied to the chemical liquid nozzle 20. Therefore, the hydrogen peroxide water and the sulfuric acid are mixed inside the chemical liquid nozzle 20, and the SPM is generated. Then, the chemical liquid nozzle 20 discharges the SPM to the substrate W. As a result, the resist film is removed from the substrate W. Step S5 ends, for example, when the third time has elapsed from the start of step S5. That is, the chemical liquid nozzle 20 discharges the SPM to the substrate W only during the third time. In step S5, the valves 81 and 201 are closed.

Next, in step S6, the controlling portion 501 controls the rinse liquid supplying portion 80 (valve 81) so as to supply the rinse liquid to the substrate W. As a result, the valve 81 is opened, and the rinse liquid is supplied to the rinse liquid nozzle 61. Therefore, the rinse liquid nozzle 61 discharges the rinse liquid to the substrate W. The residue of the SPM and the resist film is washed away by the rinse liquid. Step S6 ends, for example, when the fourth time has elapsed from the start of step S6. That is, the rinse liquid nozzle 61 discharges the rinse liquid to the substrate W only during the fourth time. In step S6, the valves 41, 51, and 201 are closed.

Next, in step S7, the controlling portion 501 accelerates the substrate W to, for example, a drying rotation speed higher than the rotation speed from step S3 to step S6 by controlling the spin motor M, and rotates the substrate W at the drying rotation speed. As a result, a large centrifugal force is applied to the rinse liquid on the substrate W, and the rinse liquid adhering to the substrate W is shaken off to the periphery of the substrate W. In this manner, the rinse liquid is removed from the substrate W, and the substrate W is dried.

Next, in step S8, the controlling portion 501 controls the spin chuck 10 so as to stop the rotation of the substrate W. As a result, the spin chuck 10 stops the rotation of the substrate W.

Next, in step S9, the controlling portion 501 controls a robot (not illustrated) to unload the substrate W from the substrate processing apparatus 1. As a result, the robot unloads the substrate W from the substrate processing apparatus 1.

Next, in step S10, it is determined whether or not the processing on all the substrates W to be processed has been completed.

When it is determined in step S10 that the processing has not been completed for all the substrates W to be processed (No), the process proceeds to step S1.

On the other hand, when it is determined in step S10 that the process has been completed for all the substrates W to be processed (Yes), the substrate processing method ends.

As described above with reference to FIG. 4, according to the substrate processing method according to Preferred Embodiment 1, the SPM is discharged to the substrate W in step S5. The SPM is derived from sulfuric acid. In particular, in Preferred Embodiment 1, in step S3, the first sulfuric acid which is the same type of liquid as the sulfuric acid is discharged to the substrate W before the SPM is discharged to the substrate W. The temperature of the first fluid when discharged to the substrate W is higher than the room temperature. On the other hand, in step S4, the first sulfuric acid discharged to the substrate W is recovered, and the first sulfuric acid is supplied to the first storage tank 204. Therefore, in step S5 of discharging the first sulfuric acid to the substrate W, the first sulfuric acid stored in the first storage tank 204 is reused. In this case, the first sulfuric acid is not used as any liquid among a plurality of types of liquids used to generate the SPM.

Therefore, it is possible to prevent the cleanliness of sulfuric acid (sulfuric acid stored in the sulfuric acid storage tank 54) used to generate the SPM from being lowered by the first sulfuric acid. In other words, the cleanliness of the SPM can be prevented from being lowered by the first sulfuric acid. Moreover, according to the substrate processing method of Preferred Embodiment 1, it is possible to reuse the first sulfuric acid discharged to the substrate W before discharging the SPM while suppressing a decrease in cleanliness of the SPM.

That is, according to the substrate processing method of Preferred Embodiment 1, it is possible to reuse the first same-type liquid (liquid) discharged to the substrate W before discharging the processing liquid while suppressing the decrease in cleanliness of the processing liquid.

### (Modified Example of Preferred embodiment 1)

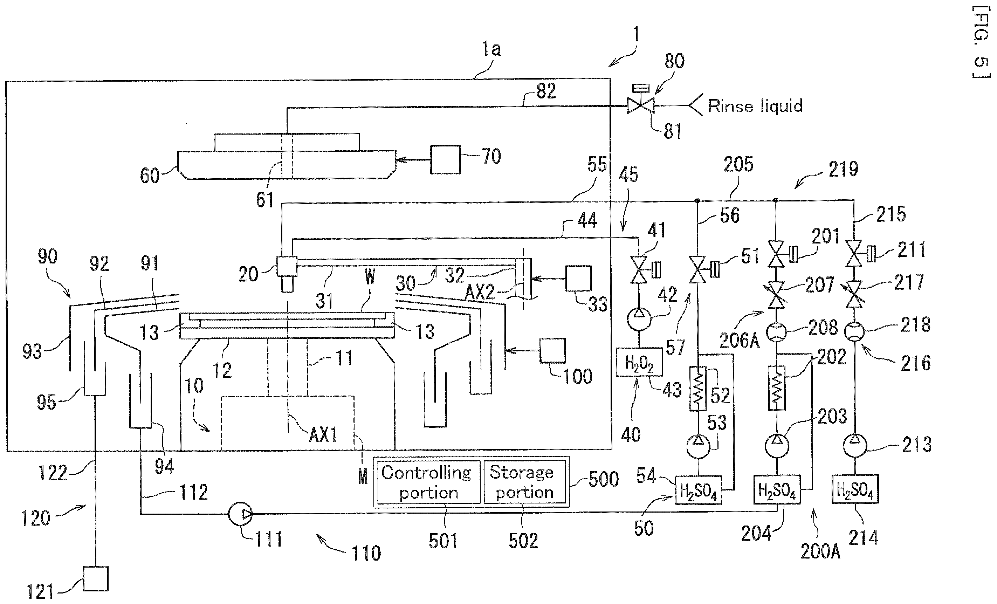

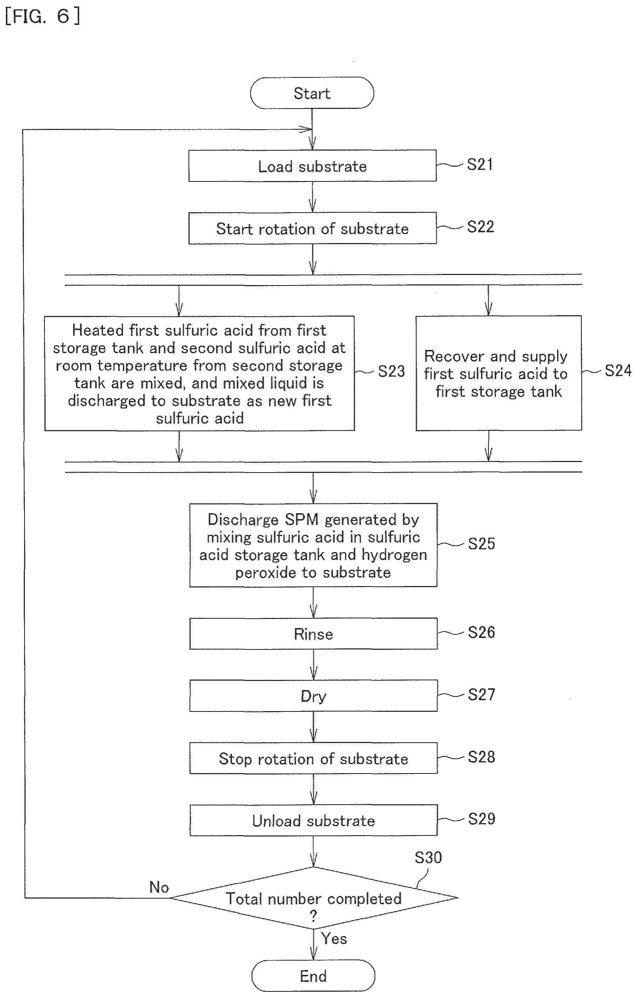

A modified example of Preferred Embodiment 1 will be described with reference to FIGS. 5 and 6. The modified example is mainly different from Preferred Embodiment 1 in that the temperature of the first sulfuric acid is adjusted by the second sulfuric acid at room temperature. Hereinafter, differences of the modified example from Preferred Embodiment 1 will be mainly described.

FIG. 5 is a schematic side view illustrating the inside of the substrate processing apparatus 1 according to the modified example of Preferred Embodiment 1. As illustrated in FIG. 5, the substrate processing apparatus 1 according to the modified example includes a same-type liquid supplying portion 200A instead of the same-type liquid supplying portion 200 in FIG. 1. The same-type liquid supplying portion 200A includes the first storage tank 204, a second storage tank 214, and a liquid supplying portion 219. The liquid supplying portion 219 includes the heating portion 202. Specifically, a supplying portion 206A of the liquid supplying portion 219 includes the heating portion 202.

The second storage tank 214 stores the second same-type liquid. The second same-type liquid is a liquid at room temperature. The second same-type liquid is the same type of liquid as the predetermined liquid. The predetermined liquid is one of a plurality of types of liquids used to generate a processing liquid.

Hereinafter, in the modified example, the processing liquid is SPM. The predetermined liquid is any one of a plurality of types of liquids used to generate the SPM. In the modified example, the predetermined liquid is sulfuric acid stored in the sulfuric acid storage tank 54. Therefore, the second same-type liquid is the same type of liquid as sulfuric acid. That is, the second same-type liquid is sulfuric acid. Hereinafter, sulfuric acid as the second same-type liquid is referred to as "second sulfuric acid."

The heating portion 202 heats the first sulfuric acid stored in the first storage tank 204. The liquid supplying portion 219 mixes the first sulfuric acid heated by the heating portion 202 and the second sulfuric acid at room temperature, and supplies the mixed liquid to the chemical liquid nozzle 20 as new first sulfuric acid. According to the modified example, by mixing the heated first sulfuric acid and the second sulfuric acid at room temperature, the temperature of new first sulfuric acid to be supplied to the chemical liquid nozzle 20 can be easily adjusted.

Specifically, the liquid supply supplying portion 219 of the same-type liquid supplying portion 200A includes the supplying portion 206A and a supplying portion 216.

The supplying portion 206A adjusts the flow rate of the first sulfuric acid flowing through the piping 205. That is, the supplying portion 206A adjusts the flow rate of the first sulfuric acid mixed with the second sulfuric acid. The first sulfuric acid supplied by the supplying portion 206A is heated by the heating portion 202.

Specifically, the supplying portion 206A further includes a flow control valve 207 and a flow meter 208 in addition to the configuration of the supplying portion 206 in FIG. 1. In the piping 205, the pump 203, the heating portion 202, the flow meter 208, the flow control valve 207, and the valve 201 are disposed in this order from upstream to downstream.

The flow meter 208 detects the flow rate of the first sulfuric acid flowing in the piping 205. The flow control valve 207 adjusts the opening degree of the piping 205 to adjust the flow rate of the first sulfuric acid flowing through the piping 205. That is, the flow control valve 207 adjusts the flow rate of the first sulfuric acid mixed with the second sulfuric acid.

The supplying portion 216 adjusts the flow rate of the second sulfuric acid flowing through the piping 215. That is, the supplying portion 216 adjusts the flow rate of the second sulfuric acid mixed with the first sulfuric acid. The temperature of the second sulfuric acid supplied by the supplying portion 216 is the room temperature. The second storage tank 214 stores the second sulfuric acid.

The sulfuric acid stored in the second storage tank 214 corresponds to an example of the "second same-type liquid" of the present invention.

The supplying portion 216 includes a valve 211, a flow control valve 217, a flow meter 218, a pump 213, and a piping 215.

One end of the piping 215 is connected to the piping 205. The other end of the piping 215 extends to the second storage tank 214. In the piping 215, the pump 213, the flow meter 218, the flow control valve 217, and the valve 211 are disposed in this order from upstream to downstream.

The pump 213 sends the second sulfuric acid stored in the second storage tank 214 to the piping 215. That is, the pump 213 supplies the second sulfuric acid stored in the second storage tank 214 to the piping 215. The flow meter 218 detects the flow rate of the second sulfuric acid flowing in the piping 215. The flow control valve 217 adjusts the opening degree of the piping 215 to adjust the flow rate of the second sulfuric acid flowing through the piping 215. That is, the flow control valve 217 adjusts the flow rate of the second sulfuric acid mixed with the first sulfuric acid. The valve 211 opens and closes a flow path of the piping 215.

When the valves 201 and 211 are opened in a state where the valve 41 and the valve 51 are closed, the first sulfuric acid set to the target temperature T1 from the first storage tank 204 and the second sulfuric acid at room temperature from the second storage tank 214 are mixed in the piping 205. As a result, the temperature of the mixed liquid is adjusted according to the mixing ratio of the first sulfuric acid and the second sulfuric acid. The mixed liquid is supplied to the common piping 55 as new first sulfuric acid, and further supplied to the chemical liquid nozzle 20.

In this case, the controlling portion 501 controls the flow control valve 207 to adjust the flow rate of the first sulfuric acid. Also, the controlling portion 501 controls the flow control valve 217 to adjust the flow rate of the second sulfuric acid.

Specifically, the controlling portion 501 controls the flow control valve 207 and the flow control valve 217 to adjust the ratio of the flow rate of the second sulfuric acid to the flow rate of the first sulfuric acid. That is, the controlling portion 501 controls the flow control valve 207 and the flow control valve 217 to adjust the mixing ratio of the first sulfuric acid and the second sulfuric acid.

Next, a substrate processing method according to a modified example will be described with reference to FIGS. 5 and 6. FIG. 6 is a flowchart illustrating a substrate processing method performed by a substrate processing apparatus according to the modified example of Preferred Embodiment 1. As illustrated in FIG. 6, the substrate processing method includes steps S21 to S30.

Steps S21 and S22 are similar to steps S1 and S2 illustrated in FIG. 4, respectively. Further, step S24 is similar to step S4 illustrated in FIG. 4. Further, steps S25 to S30 are similar to steps S5 to S10 illustrated in FIG. 4, respectively.

In the modified example, after step S22, step S23 and step S24 are performed in parallel.

In step S23, the controlling portion 501 controls the liquid supplying portion 219 (valves 201 and 211 and flow control valves 207 and 217) to mix the heated first sulfuric acid from the first storage tank 204 and the second sulfuric acid at room temperature from the second storage tank 214, and discharge the mixed liquid as new first sulfuric acid to the substrate W. As a result, the flow rate of the first sulfuric acid is adjusted by the flow control valve 207, and the valve 201 is opened. In addition, the flow rate of the second sulfuric acid is adjusted by the flow control valve 217, and the valve 211 is opened. Therefore, the heated first sulfuric acid and the second sulfuric acid at room temperature are mixed in the piping 205 to generate a mixed liquid whose temperature is adjusted. Then, the mixed liquid is supplied as new first sulfuric acid from the common piping 55 to the chemical liquid nozzle 20. As a result, the chemical liquid nozzle 20 discharges the first sulfuric acid to the substrate W. The chemical liquid nozzle 20 and the front surface of the substrate W are preheated by the first sulfuric acid. Step S23 ends, for example, when the first time has elapsed from the start of step S23. That is, the chemical liquid nozzle 20 discharges the first sulfuric acid to the substrate W only during the first time. In step S23, the valves 41, 51, and 81 are closed.

Upon completion of step S23 and step S24, the process proceeds to step S25. Even if the process of step S24 is not finished, the process can proceed to step S25 as long as step S23 is finished.

As described above with reference to FIG. 6, in the substrate processing method according to the modified example, in step S23 of discharging the first sulfuric acid to the substrate W, the heated first sulfuric acid from the first storage tank 204 and the second sulfuric acid at room temperature from the second storage tank 214 are mixed, and the mixed liquid is discharged to the substrate W as new first sulfuric acid. Therefore, according to the substrate processing method according to the modified example, the temperature of new first sulfuric acid to be supplied to the chemical liquid nozzle 20 can be easily adjusted by adjusting the mixing ratio of the heated first sulfuric acid and the second sulfuric acid at room temperature.

### (Preferred Embodiment 2)

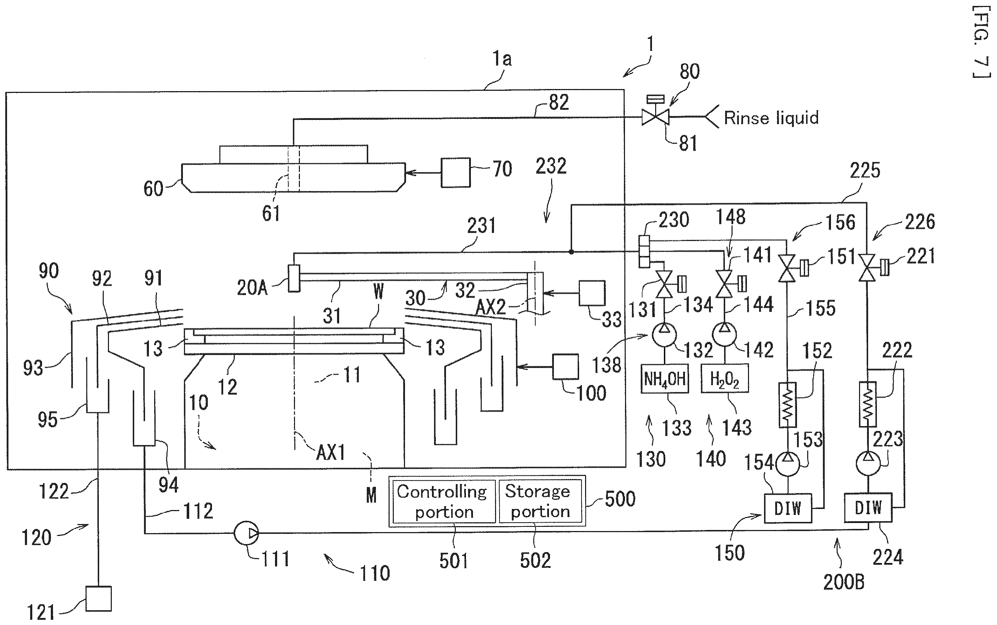

The substrate processing apparatus 1 according to Preferred Embodiment 2 of the present invention will be described with reference to FIGS. 4 and 7. Preferred Embodiment 2 is mainly different from Preferred Embodiment 1 in that SC1 is used as a processing liquid. Hereinafter, differences between Preferred Embodiment 2 and Preferred Embodiment 1 will be mainly described.

FIG. 7 is a schematic side view illustrating the inside of the substrate processing apparatus 1 according to Preferred Embodiment 2 of the present invention. The substrate processing apparatus 1 processes the substrate W with a processing liquid obtained by mixing a plurality of types of liquids.

Hereinafter, as an example, the processing liquid is an ammonia hydrogen peroxide mixture (SC1). Hereinafter, the ammonia hydrogen peroxide mixture is referred to as "SC1." SC1 is a mixed liquid of ammonia water (NH₄OH), hydrogen peroxide water (H₂O₂), and water. The water is deionized water (DIW) in Preferred Embodiment 2. In addition, the water may be a liquid similar to the rinse liquid.

In the case of SC1, the plurality of types of liquids are ammonia water, hydrogen peroxide water, and deionized water. In addition, as an example, the predetermined liquid that is any liquid among a plurality of types of liquids used to generate SC1 is deionized water. Further, as an example, the first same-type liquid which is the same type of liquid as the predetermined liquid is deionized water. Hereinafter, the deionized water as the predetermined liquid is simply referred to as "deionized water," and the deionized water as the first same-type liquid is referred to as "first deionized water." Furthermore, SC1 can be regarded as a liquid derived from deionized water. This is because deionized water is any liquid among a plurality of types of liquids used to generate SC1.

The substrate processing apparatus 1 mixes ammonia water, hydrogen peroxide water, and deionized water to generate SC1, and processes the substrate W by the SC1. In this case, the substrate processing apparatus 1 discharges the first deionized water to the substrate W before discharging the processing liquid to the substrate W. The temperature of the first deionized water is higher than the room temperature. That is, the first deionized water is heated. Therefore, it is possible to suppress a decrease in the temperature of SC1 supplied to the substrate W during the processing by SC1 performed after the first deionized water is discharged. As a result, the efficiency of processing of the substrate W by SC1 can be improved. That is, it is possible to realize desired processing by SC1 on the substrate W while reducing the amount of SC1 used.

Specifically, as illustrated in FIG. 7, the substrate processing apparatus 1 according to the modified example includes a chemical liquid nozzle 20A, an SC1 supplying portion 232, and a same-type liquid supplying portion 200B. The chemical liquid nozzle 20A corresponds to an example of a "discharge portion" of the present invention.

When processing the substrate W, the chemical liquid nozzle 20A discharges SC1 to the rotating substrate W. SC1 corresponds to an example of a "processing liquid" of the present invention.

When the chemical liquid nozzle 20A discharges the SC1 to the substrate W, the SC1 supplying portion 232 supplies the SC1 to the chemical liquid nozzle 20A.

The SC1 supplying portion 232 includes a mixing valve 230, a piping 231, an ammonia water supplying portion 130, a hydrogen peroxide water supplying portion 140, and a deionized water supplying portion 150.

When the chemical liquid nozzle 20A discharges the SC1 to the substrate W, the ammonia water supplying portion 130 supplies ammonia water to the chemical liquid nozzle 20. Specifically, the ammonia water supplying portion 130 includes an ammonia storage tank 133 and a supplying portion 138. The ammonia storage tank 133 stores ammonia water. The supplying portion 138 supplies the ammonia water stored in the ammonia storage tank 133 to the mixing valve 230.

The supplying portion 138 includes a valve 131, a pump 132, and a piping 134.

One end of the piping 134 is connected to the mixing valve 230. The piping 134 extends from the mixing valve 230 to the ammonia storage tank 133.

The valve 131 is disposed in the piping 134. The valve 131 opens and closes a flow path of the piping 134. For example, ammonia water at room temperature whose temperature is not adjusted is supplied from the ammonia storage tank 133 to the piping 134. When the valve 131 is opened, ammonia water is supplied from the piping 134 to the mixing valve 230. Ammonia water corresponds to an example of "another liquid among a plurality of types of liquids" in the present invention.

When the chemical liquid nozzle 20A discharges the SC1 to the substrate W, the hydrogen peroxide water supplying portion 140 supplies hydrogen peroxide water to the chemical liquid nozzle 20A. Specifically, the hydrogen peroxide water supplying portion 140 includes a hydrogen peroxide water storage tank 143 and a supplying portion 148. The hydrogen peroxide water storage tank 143 stores hydrogen peroxide water. The supplying portion 148 supplies the hydrogen peroxide water stored in the hydrogen peroxide water storage tank 143 to the chemical liquid nozzle 20A.

The hydrogen peroxide water supplying portion 140 includes a piping 144, a valve 141, and a pump 142.

One end of the piping 144 is connected to the mixing valve 230. The piping 144 extends from the mixing valve 230 to the hydrogen peroxide water storage tank 143.

The valve 141 is disposed in the piping 144. The valve 141 opens and closes a flow path of the piping 144. For example, hydrogen peroxide water at room temperature whose temperature is not adjusted is supplied from the hydrogen peroxide water storage tank 143 to the piping 144. When the valve 141 is opened, hydrogen peroxide water is supplied from the piping 144 to the mixing valve 230. The hydrogen peroxide water corresponds to an example of "another liquid among a plurality of types of liquids" in the present invention.

When the chemical liquid nozzle 20A discharges the SC1 to the substrate W, the deionized water supplying portion 150 supplies deionized water (specifically, a new liquid of deionized water) to the mixing valve 230. Specifically, the deionized water supplying portion 150 includes a deionized water storage tank 154 and a supplying portion 156. The deionized water storage tank 154 stores deionized water (specifically, a new liquid of deionized water). The supplying portion 156 supplies the deionized water stored in the deionized water storage tank 154 to the mixing valve 230.

The deionized water storage tank 154 corresponds to an example of a "predetermined liquid storage tank" of the present invention. The deionized water (specifically, a new liquid of deionized water) stored in the deionized water storage tank 154 corresponds to an example of the "predetermined liquid" of the present invention.

The supplying portion 156 includes a valve 151, a heating portion 152, a pump 153, and a piping 155.

One end of the piping 155 is connected to the mixing valve 230. The other end of the piping 155 extends to the deionized water storage tank 154. In the piping 155, the pump 153, the heating portion 152, and the valve 151 are disposed in this order from upstream to downstream.

The pump 153 sends the deionized water stored in the deionized water storage tank 154 to the piping 155. That is, the pump 153 supplies the deionized water stored in the deionized water storage tank 154 to the piping 155. The heating portion 152 heats the deionized water flowing through the piping 155 to set the temperature of the deionized water to the target temperature T10. The valve 151 opens and closes a flow path of the piping 155. The target temperature T10 is higher than the room temperature. The heating portion 152 is, for example, a heater.

The piping 155 branches between the heating portion 152 and the valve 151 and is connected to the deionized water storage tank 154. In a state where the valve 151 is closed, the deionized water heated by the heating portion 152 circulates through the deionized water storage tank 154 and the heating portion 152. Therefore, the temperature of the deionized water stored in the deionized water storage tank 154 is set to the target temperature T10.

When the valve 151 is opened, the deionized water set to the target temperature T10 is supplied from the piping 155 to the mixing valve 230.

When the chemical liquid nozzle 20A discharges the SC1 to the substrate W, the mixing valve 230 mixes the ammonia water supplied from the ammonia storage tank 133, the hydrogen peroxide water supplied from the hydrogen peroxide water storage tank 143, and the deionized water supplied from the deionized water storage tank 154 to generate the SC1 which is a mixed liquid. One end of the piping 231 is connected to the chemical liquid nozzle 20A, and the other end of the piping 231 is connected to the mixing valve 230. Therefore, the mixing valve 230 supplies SC1 to the chemical liquid nozzle 20A through the piping 231. Then, the chemical liquid nozzle 20A discharges SC1 to the rotating substrate W. As a result, the substrate W is processed by the SC1.

When the chemical liquid nozzle 20A discharges the SC1 to the substrate W, the valve 221 is closed. The temperature of SC1 at the time of discharge from the chemical liquid nozzle 20A is, for example, 40°C or more and 70°C or less.

The chemical liquid nozzle 20A discharges the first deionized water to the substrate W before discharging the SC1 to the substrate W. When the chemical liquid nozzle 20A discharges the first deionized water to the substrate W, the valves 131, 141, and 151 are closed.

When the chemical liquid nozzle 20A discharges the first deionized water to the substrate W, the same-type liquid supplying portion 200B supplies the first deionized water. Specifically, the same-type liquid supplying portion 200B supplies the first deionized water to the chemical liquid nozzle 20A.

The same-type liquid supplying portion 200B includes a supplying portion 226 and a first storage tank 224. The supplying portion 226 supplies the first deionized water stored in the first storage tank 224 to the chemical liquid nozzle 20A. The first storage tank 224 stores the first deionized water.

The first deionized water stored in the first storage tank 224 corresponds to an example of "first same-type liquid" of the present invention.

The supplying portion 226 includes a valve 221, a heating portion 222, a pump 223, and a piping 225.

One end of the piping 225 is connected to the piping 231. The other end of the piping 225 extends to the first storage tank 224. In the piping 225, the pump 223, the heating portion 222, and the valve 221 are disposed in this order from upstream to downstream.

The pump 223 sends the first deionized water stored in the first storage tank 224 to the piping 225. That is, the pump 223 supplies the first deionized water stored in the first storage tank 224 to the piping 225. The heating portion 222 heats the first deionized water flowing through the piping 225 to set the temperature of the first deionized water to the target temperature T20. The valve 221 opens and closes a flow path of the piping 225. The heating portion 222 is, for example, a heater.

The piping 225 branches between the heating portion 222 and the valve 221 and is connected to the first storage tank 224. In a state where the valve 221 is closed, the first deionized water heated by the heating portion 222 circulates through the first storage tank 224 and the heating portion 222. Therefore, the temperature of the first deionized water stored in the first storage tank 224 is set to the target temperature T20. The target temperature T20 is higher than the room temperature.

When the valve 221 is opened in a state where the valves 131, 141, and 151 are closed, the first deionized water set to the target temperature T20 is supplied from the piping 225 to the piping 231, and further supplied from the piping 231 to the chemical liquid nozzle 20A. As a result, the chemical liquid nozzle 20A discharges the first deionized water to the substrate W before discharging the SC1 to the substrate W. Therefore, before SC1 is discharged to the substrate W, the front surface of the substrate W and the chemical liquid nozzle 20A are temperature-controlled to a temperature higher than the room temperature. That is, before SC1 is discharged to the substrate W, the front surface of the substrate W and the chemical liquid nozzle 20A are preheated. As a result, it is possible to suppress a decrease in the temperature of SC1 supplied to the substrate W at the time of processing by SC1 performed after discharging the first deionized water.

In Preferred Embodiment 2, the first guard 91 receives the first deionized water scattered from the rotating substrate W in the first opposing state. In Preferred Embodiment 2, the first deionized water flowing down from the inner peripheral surface of the first guard 91 is collected in the first cup 94. The first deionized water collected in the first cup 94 is recovered by the recovery portion 110 connected to the bottom portion of the first cup 94.

In Preferred Embodiment 2, the second guard 92 receives SC1 scattered from the rotating substrate W in the second opposing state. SC1 flowing down from the inner peripheral surface of the second guard 92 is collected in the second cup 95. SC1 collected in the second cup 95 is discarded by the disposal portion 120 connected to the bottom portion of the second cup 95.

The recovery portion 110 recovers the first deionized water discharged to the substrate W and supplies the first deionized water to the first storage tank 224. Specifically, the recovery portion 110 recovers the first deionized water scattered from the substrate W through the first guard 91 and the first cup 94.

Specifically, the recovery pump 111 sends the first deionized water recovered from the first cup 94 to the first storage tank 224. As a result, the first deionized water recovered by the recovery portion 110 is stored in the first storage tank 224 and reused. That is, the recovered first deionized water is reused when preheating the front surfaces of the chemical liquid nozzle 20A and the substrate W before discharging the SC1 to the substrate W.

When the chemical liquid nozzle 20A discharges the first deionized water, the valves 131, 141, and 151 are closed. Therefore, the first deionized water stored in the first storage tank 224 is used only when preheating the front surfaces of the chemical liquid nozzle 20A and the substrate W before discharging the SC1 to the substrate W. In other words, the first deionized water stored in the first storage tank 224 is not used as any liquid among the plurality of types of liquids used to generate SC1. Moreover, the first deionized water stored in the first storage tank 224 is not used as deionized water used to generate SC1. In this manner, the recovered first deionized water is not supplied to the deionized water storage tank 154 and is not mixed with the deionized water in the deionized water storage tank 154.

Therefore, it is possible to prevent the cleanliness of deionized water (deionized water stored in the deionized water storage tank 154) used to generate SC1 from being lowered by the first deionized water. In other words, the cleanliness of SC1 can be prevented from being lowered by the first deionized water. Moreover, according to Preferred Embodiment 2, it is possible to reuse the first deionized water discharged to the substrate W before discharging SC1 while suppressing a decrease in cleanliness of SC1.

That is, according to Preferred Embodiment 2, it is possible to reuse the first same-type liquid (liquid) discharged to the substrate W before discharging the processing liquid while suppressing a decrease in cleanliness of the processing liquid.

The controlling portion 501 controls the operation of each portion of the substrate processing apparatus 1 on the basis of various types of information stored in the storage portion 502. For example, the controlling portion 501 controls the SC1 supplying portion 232.

As described above with reference to FIG. 7, according to Preferred Embodiment 2, the chemical liquid nozzle 20A discharges the first deionized water supplied from the same-type liquid supplying portion 200B to the substrate W before the SC1 is discharged to the substrate W. In this case, the temperature of the first deionized water is higher than the room temperature. Therefore, the temperature of the chemical liquid nozzle 20A is increased by the first deionized water before discharging SC1. In addition, the temperature of the front surface of the substrate W is increased by the first deionized water before discharging SC1. As a result, it is possible to suppress a decrease in the temperature of SC1 at the start of the processing of the substrate W by SC1. Therefore, the processing performance of the substrate W by SC1 can be improved. The processing performance is a processing amount of the substrate W per unit time. When the processing performance of the substrate W by SC1 can be improved, the use amount of SC1 can be reduced. That is, the amount of SC1 discarded can be reduced.

In Preferred Embodiment 2, the temperature of the first deionized water at the time of discharging the first deionized water to the substrate W is preferably approximately equal to the temperature of SC1 at the time of discharging SC1 to the substrate W. The reason is the same as in Preferred Embodiment 1. In Preferred Embodiment 2, the temperature of the first deionized water at the time of discharging the first deionized water to the substrate W is preferably higher than the temperature of the deionized water at the time of mixing the deionized water with other liquids (ammonia water and hydrogen peroxide water) among a plurality of types of liquids (ammonia water, hydrogen peroxide water, and deionized water). That is, the temperature of the first deionized water at the time of discharging the first deionized water to the substrate W is preferably higher than the temperature of the deionized water at the time of generating SC1. The reason is the same as in Preferred Embodiment 1.

The substrate processing method according to Preferred Embodiment 2 is similar to the substrate processing method illustrated in FIG. 4. However, in Preferred Embodiment 2, in step S3, the controlling portion 501 controls the same-type liquid supplying portion 200B (valve 221) such that the chemical liquid nozzle 20A discharges the first deionized water from the first storage tank 224 to the substrate W. As a result, the first deionized water is supplied to the chemical liquid nozzle 20A, and the chemical liquid nozzle 20A discharges the first deionized water to the substrate W.

On the other hand, in step S4, the controlling portion 501 controls the recovery portion 110 (recovery pump 111) so as to recover the first deionized water scattered from the substrate W and collected in the first cup 94. As a result, the recovery pump 111 is driven, and the first deionized water is recovered in the first storage tank 224 through the recovery piping 112.

In step S5, the controlling portion 501 controls the SC1 supplying portion 232 (valves 131, 141, and 151) such that the chemical liquid nozzle 20A discharges the SC1 to the substrate W. As a result, the ammonia water from the ammonia storage tank 133, the hydrogen peroxide water from the hydrogen peroxide water storage tank 143, and the deionized water from the deionized water storage tank 154 are mixed by the mixing valve 230 to generate SC1. Then, SC1 is supplied to the chemical liquid nozzle 20A, and the chemical liquid nozzle 20A discharges SC1 to the substrate W.

Here, in Preferred Embodiment 2, the processing liquid may be a hydrochloric acid hydrogen peroxide mixture (SC2). Hereinafter, the hydrochloric acid hydrogen peroxide mixture is referred to as "SC2." SC2 is a mixed liquid of hydrochloric acid (HCl), hydrogen peroxide water (H₂O₂), and water. The water is deionized water (DIW). In addition, the water may be a liquid similar to the rinse liquid.

In the case of SC2, the plurality of types of liquids are hydrochloric acid, hydrogen peroxide water, and deionized water. Also, as an example, the predetermined liquid that is any liquid among a plurality of types of liquids used to generate SC2 is deionized water. Further, as an example, the first same-type liquid which is the same type of liquid as the predetermined liquid is the first deionized water. SC2 can be regarded as a liquid derived from deionized water. When the processing liquid is SC2, hydrochloric acid is stored in the storage tank 133.

### (Modified Example of Preferred Embodiment 2)

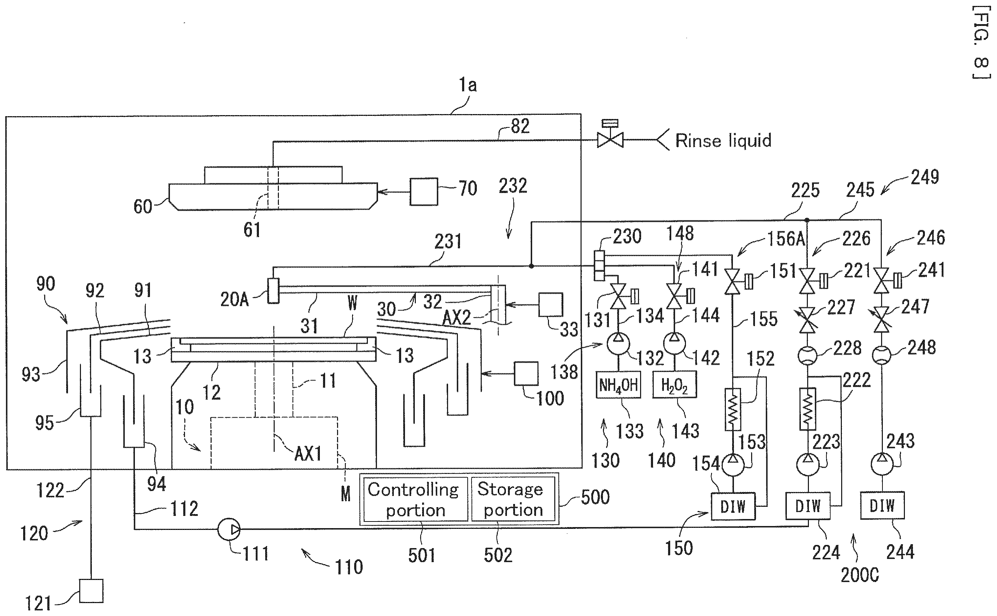

A modified example of Preferred Embodiment 2 will be described with reference to FIGS. 6 and 8. The modified example is mainly different from Preferred Embodiment 2 in that the temperature of the first deionized water is adjusted by the second deionized water at room temperature. Hereinafter, differences of the modified example from Preferred Embodiment 2 will be mainly described.

FIG. 8 is a schematic side view illustrating the inside of a substrate processing apparatus 1 according to a modified example of Preferred Embodiment 2. As illustrated in FIG. 8, the substrate processing apparatus 1 according to the modified example includes a same-type liquid supplying portion 200C instead of the same-type liquid supplying portion 200B in FIG. 7. The same-type liquid supplying portion 200C includes a first storage tank 224, a second storage tank 244, and a liquid supplying portion 249. The liquid supplying portion 249 includes a heating portion 222. Specifically, the supplying portion 226A of the liquid supplying portion 249 includes the heating portion 222.

The second storage tank 244 stores the second same-type liquid. The second same-type liquid is a liquid at room temperature. The second same-type liquid is the same type of liquid as the predetermined liquid. The predetermined liquid is one of a plurality of types of liquids used to generate a processing liquid.

Hereinafter, in the modified example, the processing liquid is SC1. The predetermined liquid is one of a plurality of types of liquids used to generate SC1. In the modified example, the predetermined liquid is deionized water stored in the deionized water storage tank 154. Therefore, the second same-type liquid is the same type of liquid as deionized water. That is, the second same-type liquid is deionized water. Hereinafter, the deionized water as the second same-type liquid is referred to as "second deionized water."

The heating portion 222 heats the first deionized water stored in the first storage tank 224. The liquid supplying portion 249 mixes the first deionized water heated by the heating portion 222 and the second deionized water at room temperature, and supplies the mixed liquid to the chemical liquid nozzle 20A as new first deionized water. According to the modified example, the temperature of new first deionized water to be supplied to the chemical liquid nozzle 20A can be easily adjusted by mixing the heated first deionized water and the second deionized water at room temperature.

Specifically, the liquid supplying portion 249 of the same-type liquid supplying portion 200C includes a supplying portion 226A and a supplying portion 246.

The supplying portion 226A adjusts the flow rate of the first deionized water flowing through the piping 225. That is, the supplying portion 226A adjusts the flow rate of the first deionized water to be mixed with the second deionized water. The first deionized water supplied by the supplying portion 226A is heated by the heating portion 222.

Specifically, the supplying portion 226A further includes a flow control valve 227 and a flow meter 228 in addition to the configuration of the supplying portion 226 in FIG. 7. The flow meter 228 detects a flow rate of the first deionized water flowing in the piping 225. The flow control valve 227 adjusts the opening degree of the piping 225 to adjust the flow rate of the first deionized water flowing through the piping 225. That is, the flow control valve 227 adjusts the flow rate of the first deionized water mixed with the second deionized water.

The supplying portion 246 adjusts the flow rate of the second deionized water flowing through the piping 245. That is, the supplying portion 246 adjusts the flow rate of the second deionized water to be mixed with the first deionized water. The temperature of the second deionized water supplied by the supplying portion 246 is the room temperature. The second storage tank 244 stores the second deionized water.

The second deionized water stored in the second storage tank 244 corresponds to an example of "second same-type liquid" of the present invention.

The supplying portion 246 includes a valve 241, a flow control valve 247, a flow meter 248, a pump 243, and a piping 245.

One end of the piping 245 is connected to the piping 225. The other end of the piping 245 extends to the second storage tank 244. The pump 243 sends the second deionized water stored in the second storage tank 244 to the piping 245. That is, the pump 243 supplies the second deionized water stored in the second storage tank 244 to the piping 245. The flow meter 248 detects a flow rate of the second deionized water flowing in the piping 245. The flow control valve 247 adjusts the opening degree of the piping 245 to adjust the flow rate of the second deionized water flowing through the piping 245. That is, the flow control valve 247 adjusts the flow rate of the second deionized water mixed with the first deionized water. The valve 241 opens and closes a flow path of the piping 245.

When the valves 221 and 241 are opened while the valves 131, 141, and 151 are closed, the first deionized water set to the target temperature T20 from the first storage tank 224 and the second deionized water at room temperature from the second storage tank 244 are mixed in the piping 225. As a result, the temperature of the mixed liquid is adjusted according to the mixing ratio of the first deionized water and the second deionized water. The mixed liquid is supplied to the piping 231 as new first deionized water, and further supplied to the chemical liquid nozzle 20A.

In this case, the controlling portion 501 controls the flow control valve 227 to adjust the flow rate of the first deionized water. The controlling portion 501 controls the flow control valve 247 to adjust the flow rate of the second deionized water.

Specifically, the controlling portion 501 controls the flow control valve 227 and the flow control valve 247 to adjust the ratio of the flow rate of the second deionized water to the flow rate of the first deionized water. That is, the controlling portion 501 controls the flow control valve 227 and the flow control valve 247 to adjust the mixing ratio of the first deionized water and the second deionized water.

Furthermore, the substrate processing method according to the modified example of Preferred Embodiment 2 is similar to the substrate processing method according to Preferred Embodiment 2 described with reference to FIG. 6. However, in the modified example, in step S23, the controlling portion 501 controls the liquid supplying portion 249 (valves 221 and 241 and flow control valves 227 and 247) to mix the heated first deionized water from the first storage tank 224 and the second deionized water at room temperature from the second storage tank 244, and discharge the mixed liquid as new first deionized water to the substrate W. As a result, the flow rate of the first deionized water is adjusted by the flow control valve 227, and the valve 221 is opened. In addition, the flow rate of the second deionized water is adjusted by the flow control valve 247, and the valve 241 is opened. Therefore, the heated first deionized water and the second deionized water at room temperature are mixed in the piping 225 to generate a mixed liquid whose temperature is adjusted. Then, the mixed liquid is supplied to the chemical liquid nozzle 20A as new first deionized water. As a result, the chemical liquid nozzle 20A discharges the first deionized water to the substrate W. The front surfaces of the chemical liquid nozzle 20A and the substrate W are preheated by the first deionized water.

In the modified example, step S24 in FIG. 6 is similar to step S4 in Preferred Embodiment 2 described with reference to FIG. 4. Further, in the modified example, step S25 in FIG. 6 is similar to step S5 of Preferred Embodiment 2 described with reference to FIG. 4.

Here, in the modified example, the processing liquid may be SC2. The predetermined liquid is one of a plurality of types of liquids used to generate SC2. In the modified example, the predetermined liquid is deionized water stored in the deionized water storage tank 154. Therefore, the second same-type liquid is the same type of liquid as deionized water. That is, the second same-type liquid is second deionized water.

The preferred embodiments (including modified examples) of the present invention have been described above with reference to the drawings (FIGS. 1 to 8). However, the present invention is not limited to the preferred embodiments described above and can be implemented in various modes within a scope not deviating from its gist. Also, it is possible to modify, as appropriate, the plurality of constituent elements disclosed in the preferred embodiments described above. For example, a certain constituent element among all constituent elements of a certain preferred embodiment may be added to the constituent elements of another preferred embodiment or some constituent elements among all constituent elements of a certain preferred embodiment may be deleted from the preferred embodiment.

The drawings mainly illustrate the respective constituent elements schematically to facilitate understanding of the invention and there are cases where thicknesses, lengths, numbers, intervals, etc., of the respective constituent elements illustrated differ from the actual ones due to convenience of drawing preparation. Also, the arrangements of the respective constituent elements indicated in the preferred embodiments described above are but an example, are not restricted in particular, and can obviously be changed variously within a scope of practically not deviating from the effects of the present invention.
(1) In the Preferred Embodiment 1 and Preferred Embodiment 2 (including modified examples), the first same-type liquid (first sulfuric acid, first deionized water) and the second same-type liquid (second sulfuric acid, second deionized water) are, for example, liquids that do not contribute to the processing of the substrate W.
(2) In FIGS. 1 and 5, the nozzle that discharges the first sulfuric acid to the substrate W may be provided separately from the chemical liquid nozzle 20 that discharges the SPM to the substrate W. In FIGS. 7 and 8, the nozzle that discharges the first deionized water to the substrate W may be provided separately from the chemical liquid nozzle 20A that discharges the SC1 to the substrate W.
(3) In FIGS. 1, 5, 7, and 8, for example, the SPM may be discarded from the first guard 91 and the first cup 94. In this case, a drainage piping branching from the recovery piping 112 is provided. When the SPM is discarded, the SPM is discharged from the drainage piping, and the recovery piping 112 to the first storage tank 204 is closed. On the other hand, when the first sulfuric acid is recovered, the drainage piping is closed with a valve. The same applies to the case of discarding SC1 and SC2.
(4) The concentration of the first sulfuric acid in the first storage tank 204 may be different from the concentration of the sulfuric acid in the sulfuric acid storage tank 54. The concentration of the second sulfuric acid in the second storage tank 214 may be different from the concentration of the sulfuric acid in the sulfuric acid storage tank 54. The concentration of the first sulfuric acid in the first storage tank 204 may be different from the concentration of the second sulfuric acid in the second storage tank 214. The temperature of the first sulfuric acid in the first storage tank 204 may be different from the temperature of the sulfuric acid in the sulfuric acid storage tank 54. The temperature of the second sulfuric acid in the second storage tank 214 may be different from the temperature of the sulfuric acid in the sulfuric acid storage tank 54.
(5) The temperature of the first deionized water in the first storage tank 224 may be different from the temperature of the deionized water in the deionized water storage tank 154. The temperature of the second deionized water in the second storage tank 244 may be different from the temperature of the deionized water in the deionized water storage tank 154.
(6) In Preferred Embodiment 1 (including modified examples), the SPM may be recovered and reused. In particular, in Preferred Embodiment 1 (including the modified example), since the use amount of the SPM can be reduced, the consumption of power (for example, power for temperature control) when the SPM is reused can be suppressed.
(7) In FIGS. 1, 5, 7, and 8, the spin chuck 10 is a gripping-type chuck, but the spin chuck 10 is not limited to the gripping-type chuck. For example, the spin chuck 10 may be a vacuum-type chuck.

### Industrial Applicability

The present invention relates to a substrate processing apparatus and a substrate processing method, and has industrial applicability.

### Reference Signs List

1: Substrate processing apparatus
10: Spin chuck (substrate holding portion)
20,20A: Chemical liquid nozzle (discharge portion)
54: Sulfuric acid storage tank (predetermined liquid storage tank)
110: Recovery portion
200,200A,200B,200C: Same-type liquid supplying portion
202,222: Heating portion
204,224: First storage tank
214,244: Second storage tank
219,249: Liquid supplying portion
W: Substrate

## Claims

1. A substrate processing apparatus for processing a substrate by discharging a processing liquid obtained by mixing a plurality of types of liquids to the substrate, the substrate processing apparatus comprising:
a substrate holding portion which holds and rotates the substrate;
a predetermined liquid storage tank which stores a predetermined liquid, any one of the plurality of types of liquids used to generate the processing liquid;
a same-type liquid supplying portion which includes a first storage tank which stores a first same-type liquid, which is a liquid of the same type as the predetermined liquid, and supplies the first same-type liquid;
a discharge portion which discharges the first same-type liquid supplied from the same-type liquid supplying portion to the substrate before discharging the processing liquid derived from the predetermined liquid to the substrate; and
a recovery portion which recovers the first same-type liquid discharged to the substrate and supplies the first same-type liquid to the first storage tank,
wherein a temperature of the first same-type liquid supplied from the same-type liquid supplying portion is higher than room temperature, and
the first same-type liquid is not used as any liquid among the plurality of types of liquids.

2. The substrate processing apparatus according to claim 1,
wherein a temperature of the first same-type liquid when discharged to the substrate is approximately equal to a temperature of the processing liquid when discharged to the substrate.

3. The substrate processing apparatus according to claim 1,
wherein a temperature of the first same-type liquid when discharged to the substrate is higher than a temperature of the predetermined liquid when the processing liquid is generated.

4. The substrate processing apparatus according to any one of claims 1 to 3,
wherein the same-type liquid supplying portion further includes a second storage tank, which stores a second same-type liquid, which is at room temperature and of the same type as the predetermined liquid, and a liquid supplying portion, which mixes the first same-type liquid and the second same-type liquid, supplies the mixed liquid as a new first same-type liquid to the discharge portion, and
the liquid supplying portion includes a heating portion, which heats the first same-type liquid stored in the first storage tank.

5. The substrate processing apparatus according to any one of claims 1 to 3,
wherein the processing liquid is a sulfuric acid hydrogen peroxide mixture obtained by mixing sulfuric acid and hydrogen peroxide water, and the first same-type liquid is sulfuric acid.

6. The substrate processing apparatus according to any one of claims 1 to 3,
wherein the processing liquid is an ammonia hydrogen peroxide mixture in which ammonia water, hydrogen peroxide water, and water are mixed, and the first same-type liquid is water, or
the processing liquid is a hydrochloric acid hydrogen peroxide mixture in which hydrochloric acid, hydrogen peroxide water, and water are mixed, and the first same-type liquid is water.

7. A substrate processing method of processing a substrate by discharging a processing liquid, obtained by mixing a plurality of types of liquids, to the substrate, the substrate processing method comprising:
discharging the processing liquid derived from a predetermined liquid to the substrate;
a step of discharging a first same-type liquid, which is a liquid of the same type as the predetermined liquid, to the substrate before discharging the processing liquid to the substrate; and
a step of recovering the first same-type liquid discharged to the substrate and supplying the first same-type liquid to a first storage tank,
wherein the predetermined liquid is any one of the plurality of types of liquids used to generate the processing liquid,
a temperature of the first same-type liquid when discharged to the substrate is higher than room temperature,
in the step of discharging the first same-type liquid to the substrate, the first same-type liquid stored in the first storage tank is reused, and
the first same-type liquid is not used as any liquid among the plurality of types of liquids.

8. The substrate processing method according to claim 7,
wherein a temperature of the first same-type liquid when discharged to the substrate is approximately equal to a temperature of the processing liquid when discharged to the substrate.

9. The substrate processing method according to claim 7,
wherein a temperature of the first same-type liquid when discharged to the substrate is higher than a temperature of the predetermined liquid when the processing liquid is generated.

10. The substrate processing method according to any one of claims 7 to 9,
wherein in the step of discharging the first same-type liquid to the substrate, the heated first same-type liquid from the first storage tank and a second same-type liquid, which is at room temperature from a second storage tank, are mixed, and the mixed liquid is discharged to the substrate as a new first same-type liquid, and
the second same-type liquid is of the same type as the predetermined liquid.

11. The substrate processing method according to any one of claims 7 to 9,
wherein the processing liquid is a sulfuric acid hydrogen peroxide mixture in which sulfuric acid and hydrogen peroxide water are mixed, and the first same-type liquid is sulfuric acid.

12. The substrate processing method according to any one of claims 7 to 9,
wherein the processing liquid is an ammonia hydrogen peroxide mixture in which ammonia water, hydrogen peroxide water, and water are mixed, and the first same-type liquid is water, or
the processing liquid is a hydrochloric acid hydrogen peroxide mixture in which hydrochloric acid, hydrogen peroxide water, and water are mixed, and the first same-type liquid is water.
